(19) Europäisches Patentamt
European Patent Office
Office européen des brevets

(11) EP 2 763 174 A2

(12) **EUROPEAN PATENT APPLICATION**

(43) Date of publication:
06.08.2014 Bulletin 2014/32

(51) Int Cl.:
*H01L 27/15* (2006.01)  *G09G 3/32* (2006.01)

(21) Application number: 13187438.0

(22) Date of filing: 04.10.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 05.02.2013 TW 102104417

(71) Applicant: Lextar Electronics Corp.
30075 Hsinchu (TW)

(72) Inventors:
• Lin, Su-Hon
205 Keelung City (TW)
• Wang, Kuan-Chieh
950 Taitung County (TW)

(74) Representative: Granleese, Rhian Jane
Marks & Clerk LLP
90 Long Acre
London WC2E 9RA (GB)

(54) **Light emitting diode display panel**

(57) A light emitting diode display panel includes a substrate and a plurality of pixels. The substrate includes a plurality of transverse signal lines and a plurality of longitudinal signal lines crossing each other. The pixels are mounted on the substrate in a matrix form. Each pixel includes a plurality of LEDs. The LEDs are electrically connected to one of the transverse signal lines and one of the longitudinal signal lines.

Fig. 1

EP 2 763 174 A2

**Description**

## BACKGROUND

Technical Field

Embodiments of the invention relates to a display device. More particularly, embodiments of the invention relate to a light emitting diode (LED) display panel.

Description of Related Art

At present, most of the display devices are implemented by using a liquid crystal panel equipped with a backlight module. With this configuration, the display devices consume a lot of electric energy. Therefore, recently some of the display devices use a more power-saving LED as a light source for the backlight module. For example, manufacturers can distribute white LEDs behind the liquid crystal panel uniformly, so that the light can be transmitted to the whole screen uniformly. However, such a display device consumes a certain amount of electric energy, which fails to satisfy the trend of the energy saving.

## SUMMARY

In view of this, an aspect of the invention provides an LED display panel, which employs the LED as the display pixel without installing the conventional liquid crystal panel. Therefore, its power consumption is lower than the power consumption of the conventional liquid crystal display device.

According to an embodiment of the invention, an LED display panel includes a substrate and a plurality of pixels. The substrate includes a plurality of transverse signal lines and a plurality of longitudinal signal lines crossing each other. The pixels are mounted on the substrate in a matrix form. Each pixel includes a plurality of LEDs. The LEDs are electrically connected to one of the transverse signal lines and one of the longitudinal signal lines.

The LED display panel provided by the aforementioned embodiments employs the LED as the display pixel, and thus, it is more power-saving than the conventional liquid crystal display. In addition, each LED in the pixel can be controlled independently by the corresponding longitudinal signal line and the corresponding transverse signal line. Therefore, different colors can be mixed to display an image.

It is to be understood that both the foregoing general description and the following detailed description are by examples, and are intended to provide further explanation of the invention as claimed.

## BRIEF DESCRIPTION OF THE DRAWINGS

The invention can be more fully understood by reading the following detailed description of the embodiment, with reference made to the accompanying drawings as follows:

Fig. 1 illustrates a top view of a LED display panel according to an embodiment of the invention;
Fig. 2 illustrates a top view along the A-A' line of the LED display panel inFig. 1;
Fig. 3 illustrates an equivalent circuit diagram of a LED display panel according to an embodiment of the invention;
Fig. 4 illustrates a function block diagram of a transverse signal control system; and
Fig. 5 illustrates a function block diagram of a longitudinal signal control system.

## DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

A general LED with a large package size cannot be miniaturized, and thus, it cannot meet the high resolution requirement of the display device. In order to meet the requirements of LED miniaturization and the high resolution, the invention provides the following LED display panel.

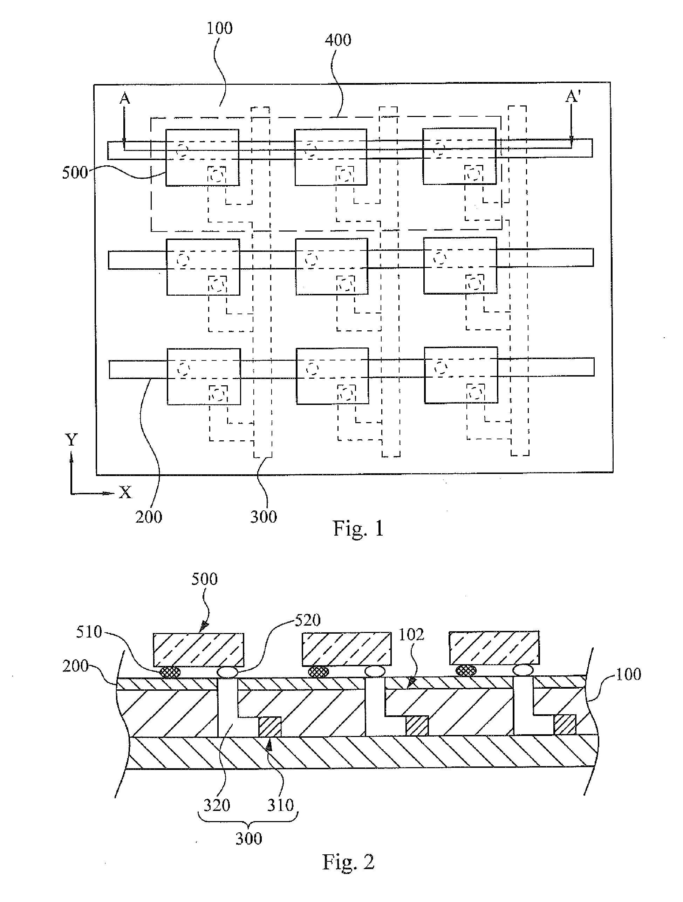

Fig. 1 illustrates a top view of a LED display panel according to an embodiment of the invention. As shown in the figure, the LED display panel includes a substrate 100 and a plurality of pixels 400. The substrate 100 includes a plurality of transverse signal lines 200 and a plurality of longitudinal signal lines 300. The transverse signal lines 200 and the longitudinal signal lines 300 cross each other. The pixels 400 are mounted on the substrate 100 in a matrix form. Each pixel 400 includes a plurality of LEDs 500. Each LED 500 is electrically connected to one of the transverse signal lines 200 and one of the longitudinal signal lines 300. The LEDs 500 in the same pixel 400 are connected to different longitudinal signal lines 300. In such a way, different LEDs 500 can be controlled respectively through different longitudinal signal lines 300. That is, each LED 500 can be controlled independently, so as to mix different colors, thereby displaying the required image.

It should be understood that, "the pixels 400 are mounted on the substrate 100 in a matrix form" described throughout the specification refers that the pixels 400 can be mounted on the substrate 100 in rows and columns. The pixels 400 disposed in rows represent the pixels which are disposed along the X direction in Fig. 1 and pixels 400 disposed in columns represents the pixels which are disposed along the Y direction in Fig. 1. For example, the pixels 400 arranged in the 20 × 20 matrix form represent 20 rows and 20 columns of pixels 400 arranged on the substrate 100. The numbers of rows and columns of pixels of the invention are not limited to this.

It should be understood that, "the transverse signal lines 200 and the longitudinal signal lines 300 cross each other" described throughout the specification refers that the lengthwise direction of the transverse signal lines 200 and the lengthwise direction of the longitudinal signal lines 300 are not parallel to each other, but cross each other. It is noted that the transverse signal lines 200 and the longitudinal signal lines 300 are not contacted with each other.

It should be understood that, the "transverse" and the "longitudinal" described throughout the specification represent two directions which are approximately perpendicular to each other. That is, the angle included between the two directions is about 90 degree.

In this embodiment, some of LEDs 500 of each pixel 400 may be a red LED, a blue LED or a green LED respectively, so as to mix different colors to display the image. In some embodiments, one of the LEDs 500 of each pixel 400 also may be a yellow LED. That is, the pixel 400 includes red, blue, green and yellow LEDs. The emitted light of the red LED is within the red-light wavelength range Wr, in which 610 nanometers (nm) $\leq$ Wr $\leq$ 640 nm. The emitted light of the green LED is within the green-light wavelength range Wg, in which 515 nm $\leq$ Wg $\leq$ 540 nm. The emitted light of the blue LED is within the blue light wavelength range Wb, wherein 440 nm $\leq$ Wb $\leq$ 470 nm. The emitted light of the yellow LED is within the yellow light wavelength range Wy, in which 560 nm $\leq$ Wy $\leq$ 590 nm.

Fig. 2 illustrates a top view along the A-A' line of the LED display panel in Fig. 1. As shown in Fig. 2, each LED 500 includes a first electrode 510 and a second electrode 520. The first electrode 510 and the second electrode 520 of the LED 500 are respectively electrically contacted with the transverse signal lines 200 and the longitudinal signal lines 300 in a flip chip manner. In such a way, the surface of the LED 500 can be electrically connected to the transverse signal lines 200 and the longitudinal signal lines 300 without bonding wires (such as the conventional gold wire). Therefore, the space for the gold wire can be omitted, so as to make the LEDs 500 arranged more concentrated, thereby reducing the size of the pixels 400. Additionally, since the gold wire tends to block the light, the light blocking problem can be solved effectively by removing the gold wire from the LED 500, so as to improve the luminous efficiency.

In some embodiments, the first electrode 510 is directly contacted with the transverse signal lines 200 and the second electrode 520 is directly contacted with the longitudinal signal wires 300, thereby facilitating the heat energy to be transmitted onto the substrate 100, so as to improve the heat dissipation ability and to prevent the LED 500 from optical degradation due to overheating.

In some embodiments, the transverse signal line 200 is disposed on a surface 102 of the substrate 100. That is, the transverse signal line 200 is attached on the surface 102 of the substrate 100. The lengthwise direction of the transverse signal line 200 is parallel to the X direction in Fig. 1 so as to electrically connect the LEDs 500 in the same row. Multiple transverse signal lines 200 are parallel to each other and are located on the substrate 100 at intervals, so as to be connected to the LEDs 500 in different rows respectively (as shown in Fig. 1).

In some embodiments, the longitudinal signal line 300 is buried in the substrate 100. The lengthwise direction of the longitudinal signal line 300 is parallel to the Y direction in Fig. 1, so as to electrically connect the LEDs 500 in the same column. Multiple longitudinal signal lines 300 are parallel to each other and are buried in the substrate 100 (i.e., below the surface 102) at intervals, so as to be connected to the LEDs 500 in different columns respectively (as shown in Fig. 1).

In some embodiments, each longitudinal signal line 300 includes a longitudinal wire 310 and a plurality of connection wires 320. The longitudinal wire 310 is buried in the substrate 100. The connection wires 320 extend onto the surface 102 of the substrate 100 from the longitudinal wire 310 buried in the substrate 100, so as to be contacted with the second electrode 520 of the LED 500. Therefore, even if the longitudinal wire 310 is buried in the substrate 100, the second electrode 520 can be powered via the connection wires 320.

Preferably, the connection wires 320 and the transverse signal lines 200 cross each other. Therefore, even if the connection wires 320 extend onto the surface 102 of the substrate 100, they are not contacted with the transverse signal lines 200, so as to prevent short circuit. Viewed from the cross section (as shown in Fig. 2), the connection wires 320 are presented as an L-shaped pattern. One end of the L-shaped pattern is directly contacted with the longitudinal wire 310 and the other end thereof is directly contacted with the second electrode 520.

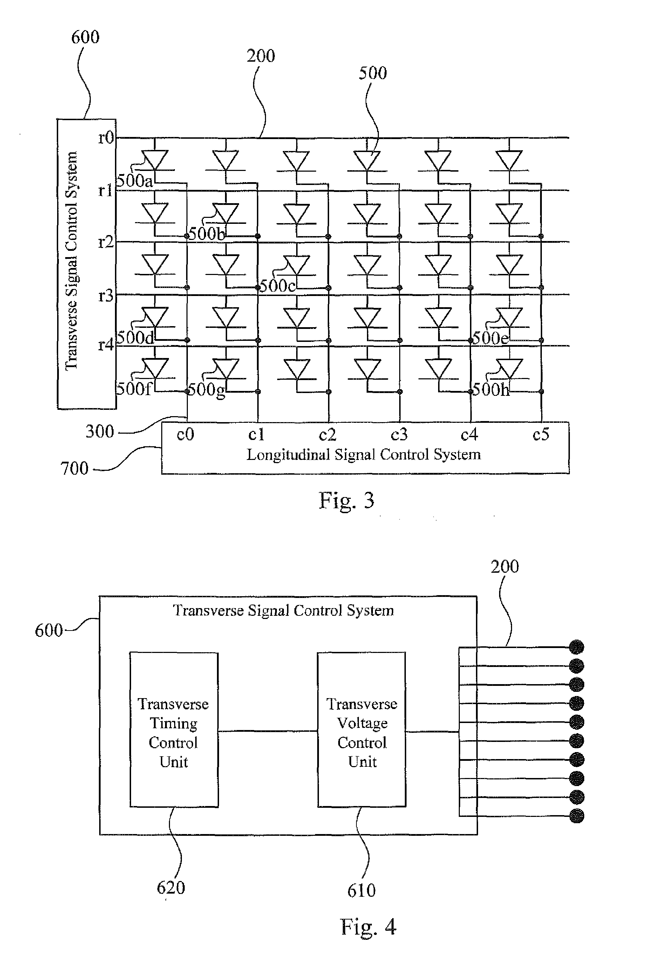

Fig. 3 illustrates an equivalent circuit diagram of a LED display panel according to an embodiment of the invention. As shown in Fig. 3, the LED display panel may include a transverse signal control system 600 and a longitudinal signal control system 700. The transverse signal control system 600 is used to drive multiple transverse signal lines 200. The longitudinal signal control system 700 is used to drive multiple longitudinal signal lines 300. That is, multiple transverse signal lines 200 are electrically connected to the transverse signal control system 600 while multiple longitudinal signal lines 300 are electrically connected to the longitudinal signal control system 700. In such a way, the transverse signal lines 200 and the longitudinal signal lines 300 can be controlled by the transverse signal control system 600 and the longitudinal signal control system 700 respectively.

Fig. 4 illustrates a function block diagram of the transverse signal control system 600. As shown in Fig.

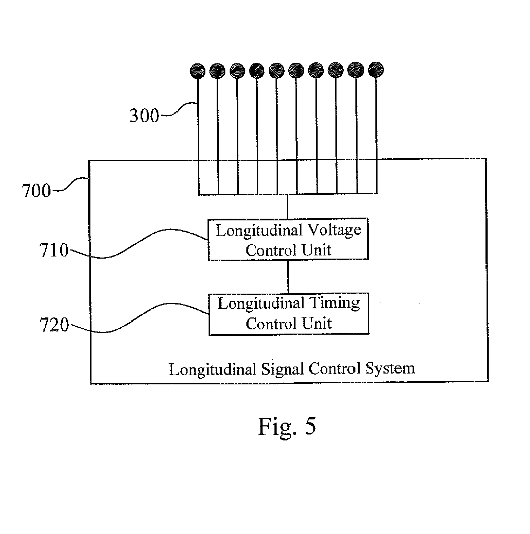

4, the transverse signal control system 600 includes a transverse voltage control unit 610. The transverse voltage control unit 610 is used to output a voltage to at least one transverse signal line 200. Fig. 5 illustrates a function block diagram of the longitudinal signal control system 700. As shown in Fig. 5, the longitudinal signal control system 700 includes a longitudinal voltage control unit 710. The longitudinal voltage control unit 710 is used to output a voltage to at least one longitudinal signal line 300. By using the transverse voltage control unit 610 together with the longitudinal voltage control unit 710, the LED 500 can be controlled, as shown in the following examples:

The transverse voltage control unit 610 can output voltage values r0, r1, r2, r3 and r4 to multiple transverse signal lines 200 respectively, i.e., the transverse voltage control unit 610 has the output voltage R = {r0, r1, r2, r3, r4}; the longitudinal voltage control unit 710 can output voltage values c0, c1, c2, c3, c4 and c5 to multiple longitudinal signal lines 300 respectively, i.e., the longitudinal voltage control unit 710 has the output voltage C = {c0, c1, c2, c3, c4, c5}; if it is supposed that the driving voltage of the LED 500 is VF, when the transverse voltage control unit 610 has the output voltage R = {VF, 0, 0, 0, 0} and the longitudinal voltage control unit 710 has the output voltage C = {0, VF, VF, VF, VF, VF}, the LED 500a located in the first column of the first row (referring to Fig. 3) is subjected to a forward voltage difference VF and then conducted to emit light. When the transverse voltage control unit 610 has the output voltage R = {0, VF, 0, 0, 0} and the longitudinal voltage control unit 710 has the output voltage C = {VF, 0, VF, VF, VF, VF}, the LED 500b located in the second column of the second row (referring to Fig. 3) is subjected to the forward voltage difference VF and then conducted to emit light. When the transverse voltage control unit 610 has the output voltage R = {0, 0, VF, 0, 0} and the longitudinal voltage control unit 710 has the output voltage C = {VF, VF, 0, VF, VF, VF}, the LED 500c located in the third column of the third row (referring to Fig. 3) is subjected to the forward voltage difference VF and then conducted to emit light. When the transverse voltage control unit 610 has the output voltage R = {0, 0, 0, VF, 0} and the longitudinal voltage control unit 710 has the output voltage C = {0, VF, VF, VF, VF, 0}, the LED 500d located in the first column of the fourth row and the LED 500e located in the sixth column of the fourth row (referring to Fig. 3) are both subjected to the forward voltage difference VF and then conducted to emit light. When the transverse voltage control unit 610 has the output voltage R = {0, 0, 0, 0, VF} and the longitudinal voltage control unit 710 has the output voltage C = {0, 0, VF, VF, VF, 0}, the LED 500f located in the first column of the fifth row, the LED 500g located in the second column of the fifth row and the LED 500h located in the sixth column of the fifth row (referring to Fig. 3) are all subjected to the forward voltage difference VF and then conducted to emit light.

Based on the foregoing examples, each LED 500 can be controlled by the transverse voltage control unit 610 and the longitudinal voltage control unit 710.

In some embodiments, the transverse voltage control unit 610 is used to output a voltage at a first level to the transverse signal lines 200. The aforesaid first level is between a zero level and the driving voltage of the LED 500. In other words, if the first level is V1, the zero level is V0 and the driving voltage is VF, then

$$V0 \le V1 \le VF,$$

In which the zero level V0 may be 0 volt and the first level V1 may be 1/2VF, 1/3VF or 2/3VF, which can be implemented by, but is not limited to be implanted by, a voltage division circuit. The driving voltage VF represents a voltage required for the LED 500 to emit light conforming to the standard brightness. Since the first level V1 may not be equal to the driving voltage VF, it can facilitate the LED 500 to emit lights with different brightness, so as to present the required image brightness more accurately.

In some embodiments, the longitudinal voltage control unit 710 is used to output a voltage at a second level to the longitudinal signal lines 300. The aforesaid second level is between the zero level and the driving voltage of the LED 500. In other words, if the second level is V2, the zero level is V0 and the driving voltage is VF, then

$$V0 \le V2 \le VF,$$

In which the zero level V0 may be 0 volt and the second level V2 may be 1/2VF, 1/3VF or 2/3VF, which can be, but is not limited to be, implemented by the voltage division circuit. The driving voltage VF represents a voltage required for the LED 500 to emit the light conforming to the standard brightness. Since the second level V2 may not be equal to the driving voltage VF, it can facilitate the LED 500 to emit lights with different brightness, so as to present the required image brightness more accurately.

In some embodiments, the first level V1 and the second level V2 are not equal and neither one thereof is the zero level. The difference between the first level V1 and the second level V2 can be used to control the brightness of the LED 500. For example, the first level V1 may be 2/3VF while the second level V2 may be 1/3VF. Therefore, the voltage difference applied to the LED 500 is 1/3VF, and the LED 500 can emit light with the corresponding brightness. In some embodiments, the second level V2 is the zero level while the first level V1 is not the zero level. Therefore, only the first level V1 can be used to control the brightness of the LED 500.

As shown in Fig. 4, in some embodiments, the transverse signal control system 600 also includes a transverse timing control unit 620 used to control a conduction time of the transverse signal lines 200. That is, the conduction time of different transverse signal lines 200 may be the same or different, which is controlled by the transverse timing control unit 620. For example, multiple transverse signal lines 200 may be conducted from up to down in sequence.

As shown in Fig. 5, in some embodiments, the longitudinal signal control system 700 also includes a longitudinal timing control unit 720 used to control a conduction time of the longitudinal signal lines 300. That is, the conduction time of different longitudinal signal lines 300 may be the same or different, which is controlled by the longitudinal timing control unit 720. For example, multiple longitudinal signal lines 300 can be conducted from left to right in sequence.

In some embodiments, the transverse timing control unit 620 and the longitudinal timing control unit 720 are used to control the transverse signal lines 200 and the longitudinal signal lines 300 electrically connected to the same LED 500 to be asynchronously conducted, so as to make the image to show a special visual effect (such as a matte effect). For example, the longitudinal signal lines 300 may be conducted after the transverse signal lines 200 have been conducted for 0.01 seconds.

In some embodiments, the transverse timing control unit 620 and the longitudinal timing control unit 720 also can control the transverse signal lines 200 and the longitudinal signal lines 300 electrically connected to the same LED 500 to be synchronously conducted, so as to show a clean image.

In some embodiments, the transverse voltage control unit 610, the transverse timing control unit 620, the longitudinal voltage control unit 710 and the longitudinal timing control unit 720 may be implemented by a central processing unit (CPU), a microprocessor, a digital signal processor (DSP) or any combination thereof used together with a small number of hardware circuits (such as the voltage division circuit).

**Claims**

1. A light emitting diode display panel, **characterized by** comprising:

 a substrate (100), comprising a plurality of transverse signal lines (200) and a plurality of longitudinal signal lines (300) crossing each other; and
 a plurality of pixels (400) mounted on the substrate (100) in a matrix form, wherein each of the pixels (400) comprises a plurality of light emitting diodes (500), and the light emitting diodes (500) are electrically connected to one of the transverse signal lines (200) and one of the longitudinal signal lines (300).

2. The light emitting diode display panel of claim 1, **characterized in that** each of the light emitting diodes (500) comprises a first electrode (510) and a second electrode (520).

3. The light emitting diode display panel of claim 2, **characterized in that** the first electrode (510) and the second electrode (520) of each of the light emitting diodes (500) are respectively electrically connected to one of the transverse signal lines (200) and one of the longitudinal signal lines (300) in a flip chip manner.

4. The light emitting diode display panel of any preceding claim, **characterized in that** the transverse signal lines (200) are disposed on a surface of the substrate (100).

5. The light emitting diode display panel of claim 4, **characterized in that** the longitudinal signal lines (300) are buried in the substrate (100).

6. The light emitting diode display panel of claim 5, **characterized in that** each of the longitudinal signal lines (300) comprises:

 a longitudinal wire (310) buried in the substrate; and
 a plurality of connection wires (320), wherein each of the connection wires (320) extends onto the surface of the substrate (100) from the longitudinal wire (310) buried in the substrate (100), so as to be contacted with the second electrode (520) of at least one of the light emitting diodes (500).

7. The light emitting diode display panel of any preceding claim, **characterized by** further comprising:

 a transverse signal control system (600) used to drive the transverse signal lines (200); and
 a longitudinal signal control system (700) used to drive the longitudinal signal lines (300).

8. The light emitting diode display panel of claim 7, **characterized in that** the transverse signal control system (600) comprises a transverse voltage control unit (610) used to output a voltage at a first level to at least one of the transverse signal lines (200), and the first level is between a zero level and a driving voltage of one of the light emitting diodes; wherein the longitudinal signal control system (700) comprises a longitudinal voltage control unit (710) used to output a voltage at a second level to at least one of the longitudinal signal lines (300), and the second level is between the zero level and the driving voltage of one of the light emitting diodes.

**9.** The light emitting diode display panel of claim 8, **characterized in that** the transverse signal control system (600) further comprises a transverse timing control unit (620) used to control a conduction time of the transverse signal lines (200); wherein the longitudinal signal control system (700) further comprises a longitudinal timing control unit (720) used to control a conduction time of the longitudinal signal lines (300).

**10.** The light emitting diode display panel of claim 9, **characterized in that** the transverse timing control unit (620) and the longitudinal timing control unit (720) are used to control one of the transverse signal lines (200) and one of the longitudinal signal lines (300) electrically connected to the same light emitting diode (500) to be asynchronously conducted.

**11.** The light emitting diode display panel of claim 9, **characterized in that** the transverse timing control unit (620) and the longitudinal timing control unit (720) are used to control one of the transverse signal lines (200) and one of the longitudinal signal lines (300) electrically connected to the same light emitting diode (500) to be synchronously conducted.

**12.** The light emitting diode display panel of any preceding claim, **characterized in that** at least some of the light emitting diodes (500) of each of the pixels (400) are a red light emitting diode, a blue light emitting diode and a green light emitting diode respectively.

**13.** The light emitting diode display panel of claim 12, **characterized in that** one of the light emitting diodes (500) of each of the pixels is a yellow light emitting diode.

Fig. 1

Fig. 2

600

200

500

Transverse Signal Control System

r0
r1
r2
r3
r4

500a
500b
500c
500d
500e
500f
500g
500h

300

c0    c1    c2    c3    c4    c5

700

Longitudinal Signal Control System

Fig. 3

200

600

Transverse Signal Control System

Transverse Timing Control Unit

Transverse Voltage Control Unit

620

610

Fig. 4

Fig. 5